(19) Europäisches Patentamt
European Patent Office
Office européen des brevets

(11) EP 2 495 818 A1

(12) **EUROPEAN PATENT APPLICATION**
published in accordance with Art. 153(4) EPC

(43) Date of publication:
**05.09.2012 Bulletin 2012/36**

(21) Application number: **10826747.7**

(22) Date of filing: **27.10.2010**

(51) Int Cl.:
***H01R 11/01*** *(2006.01)* ***H01B 5/16*** *(2006.01)*
***H01L 21/60*** *(2006.01)* ***H05K 3/36*** *(2006.01)*

(86) International application number:
**PCT/JP2010/069020**

(87) International publication number:
**WO 2011/052615 (05.05.2011 Gazette 2011/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.10.2009 JP 2009248073**

(71) Applicant: **Sumitomo Bakelite Company Limited**
**Shinagawa-ku**
**Tokyo 140-0002 (JP)**

(72) Inventors:
- **KAGIMOTO Tomohiro**
  **Tokyo 140-0002 (JP)**
- **CHUMA Toshiaki**
  **Tokyo 140-0002 (JP)**

(74) Representative: **Vossius, Corinna et al**
**Dr. Volker Vossius**
**Patent- und Rechtsanwaltskanzlei**
**Geibelstrasse 6**
**81679 München (DE)**

(54) **CONDUCTIVE CONNECTION MATERIAL AND TERMINAL-TO-TERMINAL CONNECTION METHOD USING SAME**

(57) The present invention provides a conductive connecting material having a multilayered structure comprising a resin composition (A) and a metal foil (B) selected from a solder foil or a tin foil, wherein the volume ratio ((A)/(B)) of the resin composition (A) and the metal foil (B) selected from a solder foil or a tin foil in the conductive connecting material is 1-40 or 20-500, as well as a method for connecting terminals using the conductive connecting material. The conductive connecting material of the present invention is preferably used for electrically connecting electronic members in an electrical or electronic component.

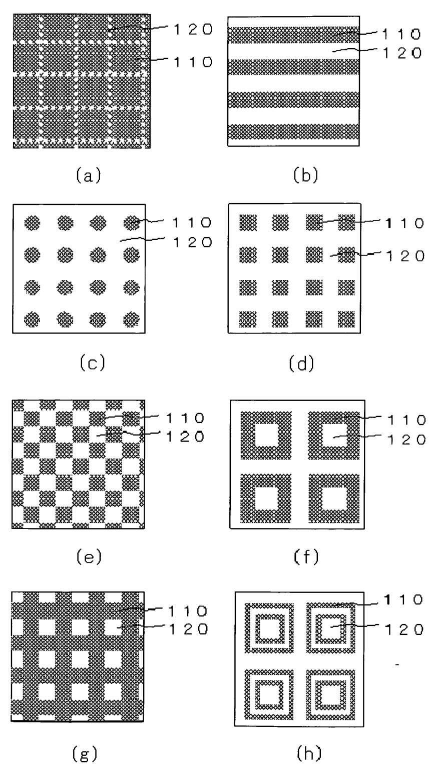


Fig. 1

EP 2 495 818 A1

## Description

TECHNICAL FIELD

The present invention relates to a conductive connecting material used for electrically connecting electronic members in an electrical or electronic component, and to a method for connecting terminals using the conductive connecting material.

BACKGROUND ART

Recently, in association with the needs for enhanced performance and downsizing of electronic devices, pitch between the connection terminals in an electronic material is becoming narrower and narrower. Along with this, terminal-to-terminal connection in a fine pitch circuit has also been highly developed. As a method for connecting terminals, for example, flip chip connection techniques are known in which an anisotropic conductive adhesive or film is used to collectively connect a plurality of terminals for electrically connecting an IC chip to a circuit board. The anisotropic conductive adhesive or film is a film or a paste having conductive particles dispersed in an adhesive consisting mainly of a thermosetting resin (see, for example, Japanese Patent Unexamined Application Publication No. *Showa* 61-276873 (Patent Document 1) and Japanese Patent Unexamined Application Publication No. 2004-260131 (Patent Document 2)). This is disposed between the electronic members to be connected which are then subjected to thermal compression, thereby collectively connecting a plurality of opposing terminals while ensuring insulation between the adjacent terminals with the resin contained in the adhesive.

However, since controlling aggregation of the conductive particles is very difficult, (1) a part of the opposing terminals may not connect with each other due to insufficient contact between the conductive particles and the terminals or between the conductive particles, and (2) a leakage current may be caused due to the conductive particles remaining in a region (insulating region) of the resin other than the region (conductive region) between the opposing terminals, resulting in inadequate insulation between the adjacent terminals. Accordingly, the conventional anisotropic conductive adhesives and films have difficulty in coping with terminals at narrower pitch.

PRIOR ART DOCUMENTS

[Patent Documents]

[Patent Document 1]
Japanese Patent Unexamined Application Publication No. *Showa* 61-276873
[Patent Document 2]
Japanese Patent Unexamined Application Publication No. 2004-260131

SUMMARY OF THE INVENTION

[Problems to be Solved by the Invention]

Under such circumstances, a conductive connecting material and a method for connecting terminals have been expected that can realize favorable electric connection between the connection terminals as well as highly-reliable insulation between the adjacent terminals.

MEANS FOR SOLVING THE PROBLEMS

In order to solve the above-described problems, the present inventors have gone through intensive investigation, and, as a result of which, found that the use of a solder foil or a tin foil instead of conductive particles eases aggregation of solder or tin between the terminals, and prevents the solder or tin to remain in the resin.
Furthermore, the present inventors focused on the fact that the amount of a metal foil (metal layer) necessary for electric connection between the terminals and the amount of a resin composition necessary for ensuring insulation between adjacent terminals by surrounding the conductive region differ between the case of adhering full grid-type electronic members having the terminals placed all over the adhesion surface and the case of adhering peripheral-type electronic members having the terminals placed only at the periphery of the adhesion surface. As a result of keen examination, the inventors of the present application found that by determining the volume ratio of the resin composition and the metal

foil to lie in an appropriate range according to the proportion of the area of the adhesion surface of the adherend occupied by the terminals (area occupancy), the electric connection and the insulation reliability between the terminals become better, thereby accomplishing the present invention.

Thus, the present invention provides a conductive connecting material, a method for connecting terminals using the conductive connecting material, and an electrical or electronic component electrically connected using the conductive connecting material, described below.

(1) A conductive connecting material having a multilayered structure comprising a resin composition (A) and a metal foil (B) selected from a solder foil or a tin foil, wherein the volume ratio ((A)/(B)) of the resin composition (A) and the metal foil (B) selected from a solder foil or a tin foil is 1-40 in the conductive connecting material.

(2) The conductive connecting material according to (1) above for electrically connecting opposing terminals, which is used when the area occupancy of the terminal with respect to the adhesion area between the adherend including the terminal and the conductive connecting material is from 3% to 50%.

(3) A conductive connecting material having a multilayered structure comprising a resin composition (A) and a metal foil (B) selected from a solder foil or a tin foil, wherein the volume ratio ((A)/(B)) of the resin composition (A) and the metal foil (B) selected from a solder foil or a tin foil is 20-500 in the conductive connecting material.

(4) The conductive connecting material according to (3) above for electrically connecting opposing terminals, which is used when the area occupancy of the terminal with respect to the adhesion area between the adherend including the terminal and the conductive connecting material is 0.1% to less than 3%.

(5) The conductive connecting material according to any one of (1)-(4) above wherein the resin composition (A) comprises a polymer component having a weight-average molecular weight of 8,000-1,000,000.

(6) The conductive connecting material according to (5) above, wherein the polymer component comprises at least one type selected from the group consisting of a phenoxy resin, a (meth)acrylic resin and a polyimide resin.

(7) The conductive connecting material according to (5) or (6) above, wherein the blending amount of the polymer component is 5-50% by weight to the total weight of the resin composition (A).

(8) The conductive connecting material according to any one of (1)-(7) above, wherein the resin composition (A) comprises a compound having a phenolic hydroxyl group and/or a carboxyl group.

(9) The conductive connecting material according to (8) above, wherein the compound having a phenolic hydroxyl group and/or a carboxyl group comprises a compound represented by General Formula (1) below:

$$HOOC\text{-}(CH_2)n\text{-}COOH \qquad (1)$$

where, n is an integer of 1-20.

(10) The conductive connecting material according to (8) or (9) above, wherein the compound having a phenolic hydroxyl group and/or a carboxyl group comprises a compound represented by General Formula (2) and/or (3) below:

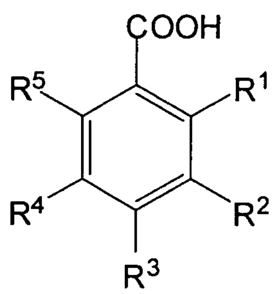

(2)

where, $R^1$-$R^5$ are each independently a monovalent organic group, provided that at least one of $R^1$-$R^5$ is a hydroxyl group,

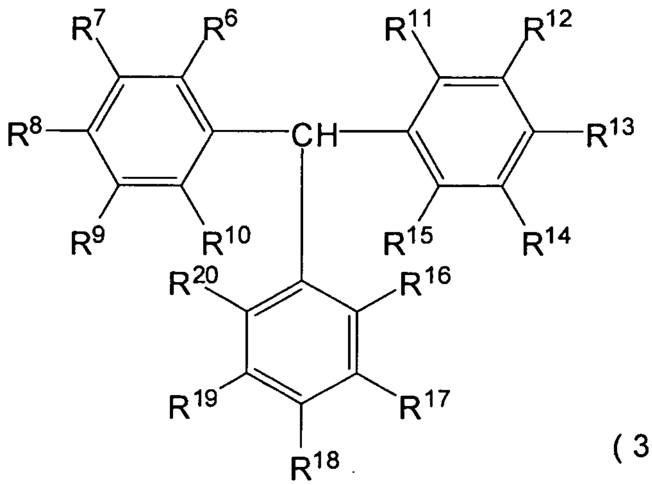

(3)

where, $R^6$-$R^{20}$ is each independently a monovalent organic group, provided that at least one of $R^6$-$R^{20}$ is a hydroxyl group or a carboxyl group.

(11) The conductive connecting material according to any one of (1)-(10), wherein the melting point of the metal foil is 100˚C-330˚C.

(12) The conductive connecting material according to any one of (1)-(11) above, comprising a multilayered structure comprising resin composition layer/metal foil layer/resin composition layer.

(13) The conductive connecting material according to any one of (1)-(11) above, comprising a multilayered structure comprising resin composition layer/metal foil layer.

(14) A method for connecting terminals comprising the steps of: arranging the conductive connecting material according to any one of (1)-(13) above between the opposing terminals; heating the conductive connecting material at a temperature that is equal to or higher than the melting point of the metal foil and that does not complete curing of the resin composition; and curing the resin composition.

According to the connection method described above, when the area occupancy of the terminal with respect to the adhesion area between the adherend including the terminals and the conductive connecting material is 3% to 50%, the conductive connecting material used preferably has a volume ratio ((A)/(B)) of a resin composition (A) and a metal foil (B) selected from a solder foil or a tin foil of 1-40 in the conductive connecting material.

Moreover, when the area occupancy of the terminal with respect to the adhesion area between the adherend including the terminals and the conductive connecting material is 0.1% to less than 3%, the conductive connecting material used preferably has a volume ratio ((A)/(B)) of a resin composition (A) and a metal foil (B) selected from a solder foil or a tin foil of 20-500 in the conductive connecting material.

(15) A method for connecting terminals comprising the steps of: arranging the conductive connecting material according to any one of (1)-(13) above between opposing terminals; heating the conductive connecting material at a temperature that is equal to or higher than the melting point of the metal foil and that softens the resin composition; and solidifying the resin composition.

According to the connection method described above, when the area occupancy of the terminal with respect to the adhesion area between the adherend including the terminals and the conductive connecting material is 3% to 50%, the conductive connecting material used preferably has a volume ratio ((A)/(B)) of a resin composition (A) and a metal foil (B) selected from a solder foil or a tin foil of 1-40 in the conductive connecting material.

Moreover, when the area occupancy of the terminal with respect to the adhesion area between the adherend including the terminals and the conductive connecting material is 0.1% to less than 3%, the conductive connecting material used preferably has a volume ratio ((A)/(B)) of a resin composition (A) and a metal foil (B) selected from a solder foil or a tin foil of 20-500 in the conductive connecting material.

(16) An electric or electronic component, wherein electronic members are electrically connected using the conductive connecting material according to any one of (1)-(13) above.

EFFECT OF INVENTION

By using a conductive connecting material of the present invention, solder or tin can easily be aggregated between opposing terminals, thereby obtaining good electric connection. Furthermore, since a metal foil is used, conductive particles can be prevented from remaining in the insulating region, thereby obtaining highly-reliable insulation. In a preferable aspect of the present invention, a plurality of terminals can be collectively connected in a fine pitch circuit

such as a semiconductor device. In addition, by using the conductive connecting material of the present invention, a connection terminal can be produced on an electrode of an electronic member by a convenient method.

BRIEF DESCRIPTION OF THE DRAWINGS

[Figure 1] Figure 1 is a schematic plan view showing examples of a shape of a metal foil layer used with the present invention.

[Figure 2] Figure 2 is a cross-sectional view schematically showing one exemplary state of a substrate and a conductive connecting material after arranging the conductive connecting material between the terminals according to a method for connecting terminals of the present invention.

[Figure 3] Figure 3 is a cross-sectional view schematically showing one exemplary state of a substrate, a conductive region and an insulating region after heating, curing/solidifying the conductive connecting material arranged between the terminals according to a method for connecting terminals of the present invention.

[Figure 4] Figure 4 is a cross-sectional view schematically showing one exemplary state of a substrate and a conductive connecting material after arranging the conductive connecting material between the terminals according to a method for connecting terminals of the present invention.

EMBODIMENTS FOR CARRYING OUT THE INVENTION

Hereinafter, a conductive connecting material, a method for connecting terminals using the conductive connecting material and an electrical or electronic component electrically connected using the conductive connecting material according to the present invention will each be described in a specific manner.

1. Conductive connecting material

A conductive connecting material of the present invention comprises a resin composition and a metal foil selected from a solder foil or a tin foil. It takes a form of a multilayered body having a multilayer structure of a resin composition layer and a metal foil layer, where the resin composition layer and the metal foil layer may each be either a single layer or multiple layers. The multilayered structure of the conductive connecting material is not particularly limited, and may be a two-layer structure made of a resin composition layer and a metal foil layer (resin composition layer/metal foil layer), a three-layer structure or a multilayer structure having more layers, including a plurality of either or both of the resin composition layers and metal foil layers. When a plurality of resin composition layers or metal foil layers are used, the composition of each layer may be the same or different.

According to one embodiment of the present invention, in view of reducing the oxide layer on the metal foil with a compound having a phenolic hydroxyl group and/or a carboxyl group, the layers above and beneath the metal foil layer are preferably resin composition layers. For example, a three-layered structure (resin composition layer/metal foil layer/resin composition layer) is favorable. In this case, the thickness of the resin composition layers on both sides of the metal foil layer may be the same or different. The thickness of the resin composition layer can appropriately be adjusted according to the thickness of the conductors of the terminals to be connected. For example, when a conductive connecting material whose resin composition layers on both sides of a metal foil layer have different thicknesses is used to produce a connection terminal, the thinner layer is preferably placed on the connection terminal side (electrode side). By making the distance between the metal foil and the connection terminal shorter, aggregation of solder or a tin component to the part of the connection terminal can readily be suppressed.

According to a first embodiment of the present invention, the volume ratio ((A)/(B)) of a resin composition (A) and a metal foil (B) selected from a solder foil or a tin foil in the conductive connecting material is 1-40. The volume ratio ((A)/(B)) is preferably 2-30, more preferably 3-25, and still more preferably 4-20. Preferably, a conductive connecting material of the present invention is used for electrically connecting opposing terminals. In particular, a conductive connecting material having the volume ratio ((A)/(B)) of 1-40 is preferably used when the area occupancy of the terminal with respect to the adhesion area of the adherend including the terminals and the conductive connecting material is 3% to 50%. Preferably, it is used when the area occupancy of the terminal is 4% to 40%, and more preferably 5% to 35%. For example, a conductive connecting material according to the first embodiment of the present invention is preferably used for electrically connecting the opposing terminals of full grid-type adherends where the terminals are placed all over the adhesion surface.

According to a second embodiment of the present invention, the volume ratio ((A)/(B)) of a resin composition (A) and a metal foil (B) selected from a solder foil or a tin foil in the conductive connecting material is 20-500. The volume ratio ((A)/(B)) is preferably 25-400, more preferably 30-300, and still more preferably 35-200. A conductive connecting

material of the present invention is preferably used for electrically connecting opposing terminals. In particular, a conductive connecting material having the volume ratio ((A)/(B)) of 20-500 is preferably used when the area occupancy of the terminal with respect to the adhesion area between the adherend including the terminals and the conductive connecting material is 0.1% to less than 3%. Preferably, it is used when the area occupancy of the terminal is 0.2% to 2.8%, and more preferably 0.3% to 2.5%. For example, the conductive connecting material of the second embodiment of the present invention is preferably used for electrically connecting opposing terminals of peripheral-type adherends where the terminals are arranged only at the periphery of the adhesion surface.

As described above, the volume ratio of the resin composition (A) and the metal foil (B) in the conductive connecting material is varied according to the area occupancy of the terminal with respect to the adhesion area of the adherend. By doing so, good electric connection between connection terminals as well as highly-reliable insulation between adjacent terminals can be realized. When the content of the metal foil is too low relative to the area occupancy of the terminal with respect to the adhesion area of the adherend, the number of unconnected terminals may increase due to the lack of solder or tin. On the other hand, when the content of the metal foil is too high, bridge is likely to be caused between adjacent terminals due to redundant solder or tin. Herein, the volume ratio ((A)/(B)) of a resin composition (A) and a metal foil (B) selected from a solder foil or a tin foil in a conductive connecting material can be determined as below based on the specific gravity of the conductive connecting material.

$$\text{Volume ratio } ((A)/(B)) = (S(B)-S)/(S-S(A))$$

S: Specific gravity of the conductive connecting material
S(A): Specific gravity of the resin composition
S(B): Specific gravity of the metal foil

Hereinafter, a resin composition and a metal foil used with the present invention will each be described.

(1) Resin composition

The resin composition used with the present invention may be either in a liquid form or a solid form at ambient temperature. Here, the phrase "a liquid form at ambient temperature" refers to a state where the composition does not have a definite shape at ambient temperature (25˚C). A paste form is also included in the liquid form.

According to the present invention, the resin composition may be either a curable resin composition or a thermoplastic resin composition. Examples of a curable resin composition used with the present invention include those that cure upon heating or irradiation with actinic ray. A thermosetting resin composition is favorable in terms of good mechanical properties such as coefficient of thermal expansion and elastic modulus after curing. A thermoplastic resin composition used with the present invention is not particularly limited as long as it has flexibility that allows molding by heating at a predetermined temperature.

(a) Curable resin composition

Other than a curable resin, a curable resin composition used with the present invention may also include, if necessary, a polymer component, a curing agent, a curing accelerator, a compound having a phenolic hydroxyl group and/or a carboxyl group, a silane coupling agent and the like.

(i) Curable resin

In general, a curable resin used with the present invention is not particularly limited as long as it can be used as an adhesive component for producing a semiconductor device. Examples of the curable resin include an epoxy resin, a phenoxy resin, a silicon resin, an oxetane resin, a phenol resin, a (meth)acrylate resin, a polyester resin (unsaturated polyester resin), a diallyl phthalate resin, a maleimide resin, a polyimide resin (polyimide precursor resin) and a bismaleimide-triazine resin. In particular, a thermosetting resin containing at least one selected from the group consisting of an epoxy resin, a (meth)acrylate resin, a phenoxy resin, a polyester resin, a polyimide resin, a silicon resin, a maleimide resin and a bismaleimide-triazine resin is preferably used. Among them, an epoxy resin is preferably used in view of good curing and preserving properties, and good thermal resistance, moisture resistance and chemical resistance of a cured product thereof. These curable resins may be used alone or two or more types thereof may be used in combination.

The content of the curable resin may appropriately be determined according to the form of the curable resin composition.

For example, if the curable resin composition is in a liquid form, the content of the curable resin with respect to the total weight of the curable resin composition is preferably 10% by weight or more, more preferably 15% by weight or more, still more preferably 20% by weight or more, still more preferably 25% by weight or more, yet still more preferably 30% by weight or more, and particularly preferably 35% by weight or more. At the same time, the content of the curable resin is preferably less than 100% by weight, more preferably equal to or less than 95% by weight, still more preferably equal to or less than 90% by weight, still more preferably equal to or less than 75% by weight, yet still more preferably equal to or less than 65% by weight, and particularly preferably equal to or less than 55% by weight.

If the curable resin composition is in a solid form, the content of the curable resin with respect to the total weight of the curable resin composition is preferably 5% by weight or more, more preferably 10% by weight or more, still more preferably 15% by weight or more and particularly preferably 20% by weight or more. At the same time, the content of the curable resin is preferably 90% by weight or less, more preferably 85% by weight or less, still more preferably 80% by weight or less, still more preferably 75% by weight or less, yet still more preferably 65% by weight or less, and particularly preferably 55% by weight or less.

Sufficient electric connection strength and mechanical adhesive strength between the terminals can be ensured when the content of the curable resin is within the above-mentioned range.

According to the present invention, any curable resin that is either in a liquid form or a solid form at room temperature can be used. A curable resin that is in a liquid form at room temperature and a curable resin that is in a solid form at room temperature may be used in combination. When the curable resin composition is in a liquid form, a curable resin that is in a liquid form at room temperature is preferably used. When the curable resin composition is in a solid form, a curable resin that is either in a liquid form or a solid form may be used, where a polymer component is preferably used in combination as appropriate when a curable resin in a solid form is used.

Preferable examples of an epoxy resin that is in a liquid form at room temperature (25˚C) include a bisphenol-A epoxy resin and a bisphenol-F epoxy resin. A bisphenol-A epoxy resin and a bisphenol-F epoxy resin may also be used in combination.

The epoxy equivalent of the epoxy resin that is in a liquid form at room temperature is preferably 150-300 g/eq, more preferably 160-250 g/eq and particularly preferably 170-220 g/eq. If the epoxy equivalent is lower than the lower limit mentioned above, the shrinkage percentage of the cured product is likely to increase, which may result in warpage. On the other hand, if the epoxy equivalent exceeds the upper limit mentioned above, reactivity with a film-forming resin, particularly a polyimide resin, is likely to be reduced when such film-forming resin is used in combination.

Examples of an epoxy resin that is in a solid form at room temperature (25˚C) include a bisphenol-A epoxy resin, a bisphenol-S epoxy resin, a phenol novolac epoxy resin, a cresol novolac epoxy resin, a glycidyl amine epoxy resin, a glycidyl ester epoxy resin, a trifunctional epoxy resin and a tetrafunctional epoxy resin. Among them, a solid trifunctional epoxy resin, a cresol novolac epoxy resin and the like are favorable. These epoxy resins may be used alone or two or more types thereof may be used in combination.

The epoxy equivalent of the epoxy resin that is in a solid form at room temperature is preferably 150-3000 g/eq, more preferably 160-2500 g/eq and particularly preferably 170-2000 g/eq.

A softening point of an epoxy resin that is in a solid form at room temperature is preferably 40-120˚C, more preferably 50-110˚C, and particularly preferably 60-100˚C. When the softening point lies within the above-mentioned range, tackiness can be suppressed and thus handling can be easier.

(ii) Polymer component

In a case where a curable resin composition in a solid form is used, the above-described curable resin and polymer component are preferably used in combination. A polymer component used in the present invention has a weight-average molecular weight of preferably 8,000 or more, more preferably 8,500 or more, and particularly preferably 9,000 or more. In addition, a weight-average molecular weight of a polymer component is preferably 1,000,000 or less, more preferably 950,000 or less, and still more preferably 900,000 or less. A combinational use of a curable resin and a polymer component can enhance the membrane-forming property. Moreover, fluidity of a conductive connecting material before curing can be suppressed. The above-mentioned weight-average molecular weight of a polymer component can be determined by GPC (Gel Permeation Chromatography).

The polymer component that can be used with the present invention may either be a thermoplastic resin or a thermosetting resin, or they may be used in combination. Specifically, examples of a polymer component include a (meth)acrylic resin, a phenoxy resin, a polyester resin (saturated polyester resin), a polyurethane resin, a polyimide resin, a polyamide-imide resin, a siloxane-modified polyimide resin, a polybutadiene resin, a polypropylene resin, a styrene-butadiene-styrene copolymer, a styrene-ethylene-butylene-styrene copolymer, a polyacetal resin, a polyvinyl butyral resin, a polyvinyl acetal resin, butyl rubber, chloroprene rubber, a polyamide resin, an acrylonitril-butadiene copolymer, an acrylonitril-butadiene-acrylic acid copolymer, an acrylonitril-butadiene-styrene copolymer, polyvinyl acetate and nylon. Among them, a (meth)acrylic resin, a phenoxy resin and a polyimide resin are favorable. The polymer components may be used

alone or two or more types thereof may be used in combination.

Herein, a "(meth)acrylic resin" refers to a polymer of a (meth)acrylic acid or a derivative thereof, or a copolymer of a (meth)acrylic acid or a derivative thereof with other monomer. A "(meth)acrylic acid" refers to "acrylic acid or methacrylic acid" or the like.

Examples of a (meth)acrylic resin used with the present invention include polyacrylic acid, polymethacrylic acid; polyester acrylates such as polymethyl acrylate, polyethyl acrylate, polybutyl acrylate and polyacrylic acid-2-ethylhexyl; polyester methacrylates such as polymethyl methacrylate, polyethyl methacrylate and polybutyl methacrylate; polyacrylonitril, polymethacrylonitrile, polyacrylamide, a butyl acrylate-ethyl acrylate-acrylonitril copolymer, an acrylonitril-butadiene copolymer, an acrylonitril-butadiene-acrylic acid copolymer, an acrylonitril-butadiene-styrene copolymer, an acrylonitril-styrene copolymer, a methyl methacrylate-styrene copolymer, a methyl methacrylate-acrylonitril copolymer, a methyl methacrylate-alpha-methylstyrene copolymer, a butyl acrylate-ethyl acrylate-acrylonitril-2-hydroxyethyl methacrylate-methacrylic acid copolymer, a butyl acrylate-ethyl acrylate-acrylonitril-2-hydroxyethyl methacrylate-acrylic acid copolymer, a butyl acrylate-acrylonitril-2-hydroxyethyl methacrylate copolymer, a butyl acrylate-acrylonitril-acrylic acid copolymer and an ethyl acrylate-acrylonitril-N,N-dimethylacrylamide copolymer. Among them, a butyl acrylate-ethyl acrylate-acrylonitril copolymer and an ethyl acrylate-acrylonitril-N,N-dimethylacrylamide copolymer are favorable. These (meth)acrylic resins may be used alone or two or more types thereof may be used in combination.

The backbone of the phenoxy resin used with the present invention is not particularly limited, but examples thereof preferably include those of a bisphenol-A type, a bisphenol-F type and a biphenyl type.

A polyimide resin used with the present invention is not particularly limited as long as it is a resin having an imide bond in the recurring unit. Examples include those obtained by reacting diamine with a dianhydride, and heating and cyclodehydrating the resulting polyamide acid.

Examples of a diamine include aromatic diamines such as 3,3'-dimethyl-4,4'-diaminodiphenyl, 4,6-dimethyl-m-phenylenediamine, 2,5-dimethyl-p-phenylenediamine, and siloxanediamines such as 1,3-bis(3-aminopropyl)-1,1,3,3-tetramethyldisiloxane. The diamines may be used alone or two or more types thereof may be used in combination.

Furthermore, examples of the above-mentioned dianhydride include 3,3',4,4'-biphenyltetracarboxylic acid, pyromellitic dianhydride and 4,4'-oxydiphthalic dianhydride. The dianhydrides may be used alone or two or more types thereof may be used in combination.

The polyimide resin may be soluble or insoluble in a solvent, but it is preferably soluble in a solvent so that it can easily be made into a varnish upon mixing with other components, and thus can easily be handled. In particular, a siloxane-modified polyimide resin is preferably used in that it can be dissolved in various organic solvents.

According to the present invention, a commercially-available product may be used as such a polymer component. Moreover, the polymer component used may be blended with various types of additives such as a plasticizer, a stabilizer, an inorganic filler, an antistatic agent and a pigment to a degree that does not interfere with the effect of the present invention.

In a conductive connecting material used with the present invention, the content of the polymer component may appropriately be determined according to the form of the curable resin composition used.
For example, in the case of a curable resin composition in a solid form, the content of the polymer component with respect to the total weight of the curable resin composition is preferably 5% by weight or more, more preferably 10% by weight or more and particularly preferably 15% by weight or more. At the same time, the content is preferably 50% by weight or less, more preferably 45% by weight or less and particularly preferably 40% by weight or less. When the content of the polymer component lies within the above-described range, the fluidity of the curable resin composition prior to melting can be suppressed and thus the conductive connecting material can be handled easily.

(iii) Curing agent

Examples of a curing agent used with the present invention include phenols, acid anhydrides and amine compounds. The curing agent may appropriately be selected according to the type of the curable resin. For example, when an epoxy resin is used as the curable resin, phenols are preferably used as the curing agent for their good reactivity with the epoxy resin, small change in dimension upon curing and their suitable properties (e.g., heat resistance, moisture resistance, etc.) after curing, while bi- or higher functional phenols are more preferable for superior properties of the curable resin after curing. These curing agents may be used alone or two or more types thereof may be used in combination.

Examples of phenols include bisphenol-A, tetramethyl bisphenol-A, diallyl bisphenol-A, biphenol, bisphenol-F, diallyl bisphenol-F, trisphenol, tetrakisphenol, a phenol novolac resin and a cresol novolac resin. Among them, a phenol novolac resin and a cresol novolac resin are favorable due to their good reactivity with the epoxy resin and superior properties after curing.

The content of the curing agent may appropriately be selected according to the types of the curable resin and the curing agent used, as well as to the type and the used amount of a functional group if the later-described compound

having a phenolic hydroxyl group and/or a carboxyl group has the functional group that serves as a curing agent.
For example, when an epoxy resin is used as the curable resin, the content of the curing agent with respect to the total weight of the curable resin composition is preferably 0.1-50% by weight, more preferably 0.2-40% by weight and particularly preferably 0.5-30% by weight. When the content of the curing agent lies within the above-described range, electric connection strength and mechanical adhesive strength between the terminals can be well ensured.

(iv) Curing accelerator

Examples of a curing accelerator used with the present invention include imidazole compounds such as imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazoliumtrimellitate, 1-cyanoethyl-2-phenylimidazoliumtrimellitate, 2,4-diamino-6-[2'-methylimidazolyl(1')]-ethyl-s-triazine, 2,4-diamino-6-[2'-undecylimidazolyl (1')]-ethyl-s-triazine, 2,4-diamino-6-[2'-ethyl-4-methylimidazolyl (1')]-ethyl-s-triazine, an isocyanuric acid adduct of 2,4-diamino-6-[2'-methylimidazolyl (1')]-ethyl-s-triazine, an isocyanuric acid adduct of 2-phenylimidazole, an isocyanuric acid adduct of 2-methylimidazole, 2-phenyl-4,5-dihydroxydimethylimidazole and 2-phenyl-4-methyl-5-hydroxymethylimidazole.
The content of the curing accelerator may appropriately be determined according to the type of the curing accelerator used.
For example, when an imidazole compound is used, the content of the imidazole compound with respect to the total weight of the curable resin composition is preferably 0.001% by weight or more, more preferably 0.003% by weight or more and particularly preferably 0.005% by weight or more. At the same time, the content is preferably 1.0% by weight or less, more preferably 0.7% by weight or less and particularly preferably 0.5% by weight or less. When the content of the imidazole compound is less than the lower limit, action as a curing accelerator may not be sufficiently effective such that the curing of the curable resin composition may come short. On the other hand, when the content of the imidazole compound exceed the above-described upper limit, solder or tin may not sufficiently migrate to the surface of the terminal before completion of the curing of the curable resin composition such that the solder or tin may remain in the insulating regions causing inadequate insulation. Moreover, preservation stability of the conductive connecting material may be deteriorated.

(v) Compound having phenolic hydroxyl group and/or carboxyl group

Preferably, a compound having a phenolic hydroxyl group and/or a carboxyl group used with the present invention has an effect of reducing a metal-oxide layer such as an oxide layer on the terminal surface or the metal foil surface (fluxing function).
Examples of a compound having a phenolic hydroxyl include phenol, o-cresol, 2,6-xylenol, p-cresol, m-cresol, o-ethylphenol, 2,4-xylenol, 2,5-xylenol, m-ethylphenol, 2,3-xylenol, meditol, 3,5-xylenol, p-tert-butylphenol, catechol, p-tert-amylphenol, resorcinol, p-octylphenol, p-phenylphenol, bisphenol-F, bisphenol-AF, biphenol, diallyl bisphenol-F, diallyl bisphenol-A, trisphenol, monomers containing a phenolic hydroxyl group such as tetrakisphenol, and resins containing a phenolic hydroxyl group such as a phenol novolac resin, an o-cresol novolac resin, a bisphenol-F novolac resin and a bisphenol-A novolac resin.
Examples of a compound having a carboxyl group include an aliphatic acid anhydride, an alicyclic acid anhydride, an aromatic acid anhydride, aliphatic carboxylic acid and aromatic carboxylic acid. Examples of the aliphatic acid anhydride include succinic anhydride, polyadipic anhydride, polyazelaic anhydride and polysebacic anhydride. Examples of the alicyclic acid anhydride include methyltetrahydrophtalic anhydride, methylhexahydrophtalic anhydride, methyl himic anhydride, hexahydrophtalic anhydride, tetrahydrophtalic anhydride, trialkyltetrahydrophtalic anhydride and methyl cyclohexanedicarboxylic anhydride. Examples of the aromatic acid anhydride include phtalic anhydride, trimellitic anhydride, pyromellitic dianhydride, benzophenone tetracarboxylic anhydride, ethylene glycol bis-trimellitate and glycerol tris-trimellitate.
Examples of the aliphatic carboxylic acid include formic acid, acetate acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid, glutaric acid, adipic acid, sebacic acid, dodecanedioic acid and pimelic acid. Among them, an aliphatic carboxylic acid represented by the following Formula (1):

$$HOOC\text{-}(CH_2)_n\text{-}COOH \qquad (1)$$

where, n is an integer of 1-20,

is preferable, and adipic acid, sebacic acid and dodecanedioic acid are more preferable.

The structure of the aromatic carboxylic acid is not particularly limited, but it is preferably a compound represented by the following Formula (2) or (3).

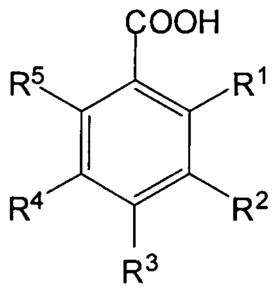

(2)

where, $R^1$-$R^5$ are each independently a monovalent organic group, and at least one of $R^1$-$R^5$ is a hydroxyl group,

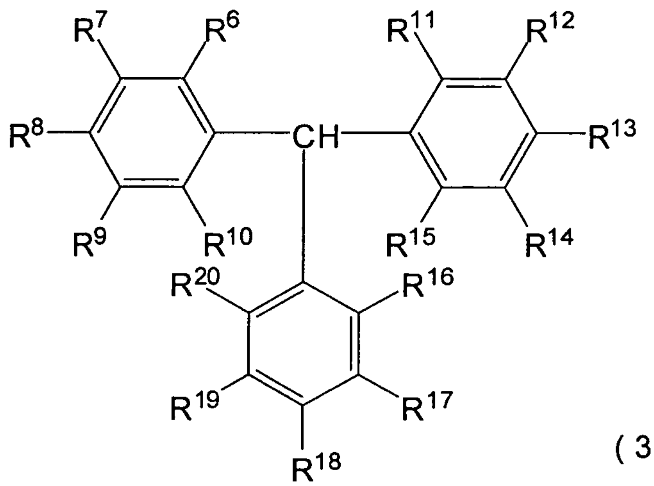

(3)

where, $R^6$-$R^{20}$ is each independently a monovalent organic group, and at least one of $R^6$-$R^{20}$ is a hydroxyl group or a carboxyl group.

Examples of aromatic carboxylic acid include benzoic acid derivatives such as benzoic acid, phthalic acid, isophthalic acid, terephthalic acid, hemimellitic acid, trimellitic acid, trimesic acid, mellophanic acid, prehnitic acid, pyromellitic acid, mellitic acid, xylyl acid, hemellitic acid, mesitylenic acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid and gallic acid (3,4,5-trihydroxybenzoic acid); and naphthoic acid derivatives such as 1,4-dihydroxy-2-naphthoic acid, 3,5-dihydroxy-2-naphthoic acid and 3,5-dihydroxy-2-naphthoic acid; phenolphthalin; and diphenolic acid.

Among them, a preferable compound having a phenolic hydroxyl group and/or a carboxyl group used with the invention not only has a fluxing function but also serves as a curing agent for a curable resin. Specifically, a compound having a phenolic hydroxyl group and/or a carboxyl group used with the present invention is preferably a compound that reduces an oxide layer on a surface of a metal such as a metal foil or a terminal, and that has a functional group that can react with a curable resin. Such a functional group may appropriately be selected according to the type of the curable resin. For example, when an epoxy resin is used as the curable resin, the functional group is preferably a functional group that can react with an epoxy group such as a carboxyl group, a hydroxyl group and an amino group. Since the compound having a phenolic hydroxyl group and/or a carboxyl group also serves as a curing agent, an oxide layer on a surface of a metal such as a metal foil or a terminal can be reduced, by which the wettability of the metal surface is increased and formation of a conductive region is facilitated, while it is added to the curable resin after formation of the conductive region, by which elastic modulus or Tg of the resin is increased. In addition, since the compound having a phenolic hydroxyl group and/or a carboxyl group serves as a curing agent, flux washing becomes unnecessary, which is advantageous in that occurrence of ion migration due to a residual flux component can be suppressed.

Such a compound having a phenolic hydroxyl group and/or a carboxyl group preferably have at least one carboxyl group. For example, when an epoxy resin is used as a curable resin, the compound may be aliphatic dicarboxylic

acid or a compound having a carboxyl group and a phenolic hydroxyl group.
A preferable example of aliphatic dicarboxylic acid includes a compound in which an aliphatic hydrocarbon group is bound with two carboxyl groups. The aliphatic hydrocarbon group may be a saturated or unsaturated acyclic group or a saturated or unsaturated cyclic group. In addition, when the aliphatic hydrocarbon group is an acyclic group, it may be either linear or branched.

Such an aliphatic dicarboxylic acid may preferably be a compound represented by Formula (1) above where n is an integer of 1-20. When "n" in Formula (1) is within the above-mentioned range, balance of the flux activity, outgassing upon adhesion, elastic modulus after curing of the conductive connecting material and glass-transition temperature becomes favorable. In particular, n is preferably equal to or higher than 3 since increase in the elastic modulus after curing of the conductive connecting material can be suppressed while the adhesion property with an adherend is enhanced. Moreover, n is preferably equal to or lower than 10 since decrease in the elastic modulus can be suppressed and connection reliability can be further enhanced.

Examples of an aliphatic dicarboxylic acid represented by Formula (1) above include glutaric acid, adipic acid, pimelic acid, suberic acid, azelaic acid, sebacic acid, undecanedioic acid, dodecanedioic acid, tridecanedioic acid, tetradecanedioic acid, pentadecanedioic acid, octadecanedioic acid, nonadecanedioic acid and eicosanedioic acid. Among them, adipic acid, suberic acid, sebacic acid and dodencanedioic acid are preferable and sebacic acid is particularly preferable.

Examples of the compound having a carboxyl group and a phenolic hydroxyl group include benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid and gallic acid (3,4,5-trihydroxybenzoic acid); naphthoic acid derivatives such as 1,4-dihydroxy-2-naphthoic acid and 3,5-dihydroxy-2-naphthoic acid; phenolphthalin; and diphenolic acid. Among them, phenolphthalin, gentisic acid, 2,4-dihydroxybenzoic acid and 2,6-dihydroxybenzoic acid are favorable, and phenolphthalin and gentisic acid are particularly favorable.

The compounds having a phenolic hydroxyl group and/or a carboxyl group may be used alone or two or more types thereof may be used in combination. Since any of the compounds easily absorb moisture and may cause void generation, the compound is preferably dried in advance before use.

The content of the compound having a phenolic hydroxyl group and/or a carboxyl group can appropriately be selected according to the form of the resin composition used.
For example, when the resin composition is in a liquid form, the content of the compound having a phenolic hydroxyl group and/or a carboxyl group with respect to the total weight of the curable resin composition is preferably 1% by weight or more, more preferably 2% by weight or more and particularly preferably 3% by weight or more. At the same time, the content is preferably 50% by weight or less, more preferably 40% by weight or less, still more preferably 30% by weight or less and particularly preferably 25% by weight or less.
In the case of a resin composition in a solid form, the content of the compound having a phenolic hydroxyl group and/or a carboxyl group with respect to the total weight of the curable resin composition is preferably 1% by weight or more, more preferably 2% by weight or more and particularly preferably 3% by weight or more. At the same time, the content is preferably 50% by weight or less, more preferably 40% by weight or less, still more preferably 30% by weight or less and particularly preferably 25% by weight or less.
When the content of the compound having a phenolic hydroxyl group and/or a carboxyl group lies within the above-mentioned range, an oxide layer on a metal foil surface or a terminal surface can be removed to an extent that allows electric connection. Furthermore, when the resin composition is a curable resin, it can efficiently be added to the resin upon curing and increase the elastic modulus or Tg of the resin. In addition, occurrence of ion migration caused by unreacted compound having a phenolic hydroxyl group and/or a carboxyl group can be suppressed.

(vi) Silane coupling agent

Examples of a silane coupling agent used with the present invention include an epoxy silane coupling agent and an aromatic-containing amino silane coupling agent. Addition of a silane coupling agent can enhance the adhesion property between the connected member and the conductive connecting material. The silane coupling agents may be used alone or two or more types thereof may be used in combination.

The content of the silane coupling agent may appropriately be selected according to the types of the connected member, the curable resin and the like. For example, the content of the silane coupling agent with respect to the total weight of the curable resin composition is preferably 0.01% by weight or more, more preferably 0.05% by weight or more and particularly preferably 0.1% by weight or more, and at the same time, preferably 2% by weight or less, more preferably 1.5% by weight or less and particularly preferably 1% by weight or less.

The curable resin composition used with the present invention may be blended, to an extent that does not interfere with the effect of the present invention, with a plasticizer, a stabilizer, a tackifier, a lubricant, an antioxidant, an inorganic filler, a filler, an antistatic agent, a pigment and the like.

According to the present invention, the curable resin composition may be prepared by mixing and dispersing each of the above-mentioned components. A method for mixing or dispersing each of the components is not particularly limited and they may be mixed or dispersed according to a conventional known method.

According to the present invention, each of the above-described components may be mixed in a solvent or without a solvent to prepare a curable resin composition in a liquid form. The solvent used for this is not particularly limited as long as it is inactive to each component, examples being ketones such as acetone, methyl ethyl ketone (MEK), methyl isobutyl ketone (MIBK), diisobutyl ketone (DIBK), cyclohexanone and diacetone alcohol (DAA); aromatic hydrocarbons such as benzene, xylene and toluene, alcohols such as methyl alcohol, ethyl alcohol, isopropyl alcohol and n-butyl alcohol, cellosolves such as methylcellosolve, ethylcellosolve, butylcellosolve, methylcellosolve acetate and ethylcellosolve acetate, N-methyl-2-pyrrolidone (NMP), tetrahydrofuran (THF), dimethylformamide (DMF), dibasic ester (DBE), 3-ethyl ethoxypropionate (EEP) and dimethyl carbonate (DMC). Furthermore, the solvent is preferably used in an amount that gives a solid content concentration of the components mixed in the solvent of 10-60% by weight.

(b) Thermoplastic resin composition

According to the present invention, a thermoplastic resin composition may also be used as a resin composition. The thermoplastic resin composition used with the present invention may contain, other than a thermoplastic resin, if necessary, a compound having a phenolic hydroxyl group and/or a carboxyl group, a silane coupling agent and the like.

(i) Thermoplastic resin

Examples of the thermoplastic resin used with the present invention include vinyl acetate series, a polyvinyl alcohol resin, a polyvinyl butyral resin, a vinyl chloride resin, a (meth)acrylic resin, a phenoxy resin, a polyester resin, a polyimide resin, a polyamide-imide resin, a siloxane-modified polyimide resin, a polybutadiene resin, an acrylic resin, a styrene resin, a polyethylene resin, a polypropylene resin, a polyamide resin, a cellulose resin, an isobutylene resin, a vinyl ether resin, a liquid crystalline polymer resin, a polyphenylene sulfide resin, a polyphenylene ether resin, a polyethersulphone resin, a polyetherimide resin, a polyetherether ketone resin, a polyurethane resin, a styrene-butadiene-styrene copolymer, a styrene-ethylene-butylene-styrene copolymer, a polyacetal resin, a polyvinyl acetal resin, butyl rubber, chloroprene rubber, an acrylonitril-butadiene copolymer, an acrylonitril-butadiene-acrylic acid copolymer, an acrylonitril-butadiene-styrene copolymer and polyvinyl acetate. The thermoplastic resin may be a single polymer or a copolymer of two or more types of the above-mentioned thermoplastic resins.

The softening point of the thermoplastic resin is not particularly limited but it is preferably lower by 10˚C or more, more preferably lower by 20˚C or more and particularly preferably lower by 30˚C or more than the melting point of a metal foil making the conductive connecting material.

The decomposition temperature of the thermoplastic resin is not particularly limited, but it is preferably higher by 10˚C or more, particularly preferably higher by 20˚C or more and more preferably higher by 30˚C or more than the melting point of a metal foil making the conductive connecting material.

The content of the thermoplastic resin may appropriately be determined according to the form of the thermoplastic resin composition used.
For example, when the thermoplastic resin composition is in a liquid form, the content of the thermoplastic resin with respect to the total weight of the thermoplastic resin composition is preferably 10% by weight or more, more preferably 15% by weight or more, still more preferably 20% by weight or more, still more preferably 25% by weight or more, yet still more preferably 30% by weight or more and particularly preferably 35% by weight or more. At the same time, the content is preferably 100% by weight or less, more preferably 95% by weight or less, still more preferably 90% by weight or less, still more preferably 75% by weight or less, yet still more preferably 65% by weight or less and particularly preferably 55% by weight or less.
When the thermoplastic resin composition is in a solid form, the content of the thermoplastic resin with respect to the total weight of the thermoplastic resin composition is preferably 5% by weight or more, more preferably 10% by weight or more, still more preferably 15% by weight or more and particularly preferably 20% by weight or more. At the same time, the content is preferably 90% by weight or less, more preferably 85% by weight or less, still more preferably 80% by weight or less, still more preferably 75% by weight or less, yet still more preferably 65% by weight or less and particularly preferably 55% by weight or less.
When the content of the thermoplastic resin lies within the above-mentioned range, sufficient electric connection strength and mechanical adhesive strength between the terminals can be ensured.

(ii) Other additives

A compound having a phenolic hydroxyl group and/or a carboxyl group, a silane coupling agent and other

additives used in the thermoplastic resin composition of the present invention may be the same as those described in "(a) Curable resin composition" above. The content of each component, preferable compounds and methods for preparing the same are also the same as those described in "Curable resin composition" above.

According to the present invention, a curable resin composition is preferably used as a resin composition. Above all, those containing 10-90% by weight of an epoxy resin, 0.1-50% by weight of a curing agent, 5-50% by weight of a polymer component and 1-50% by weight of a compound having a phenolic hydroxyl group and/or a carboxyl group with respect to the total weight of the resin composition are favorable. In addition, those containing 20-80% by weight of an epoxy resin, 0.2-40% by weight of a curing agent, 10-45% by weight of a polymer component and 2-40% by weight of a compound having a phenolic hydroxyl group and/or a carboxyl group with respect to the total weight of the resin composition are further favorable. Moreover, those containing 35-55% by weight of an epoxy resin, 0.5-30% by weight of a curing agent, 15-40% by weight of a polymer component and 3-25% by weight of a compound having a phenolic hydroxyl group and/or a carboxyl group with respect to the total weight of the resin composition are particularly favorable.

A thickness of each resin composition layer of the conductive connecting material of the present invention is not particularly limited but it is preferably 1 $\mu$m or more, more preferably 3 $\mu$m or more and particularly preferably 5 $\mu$m or more. At the same time, the thickness of the resin composition layer is preferably 200 $\mu$m or less, more preferably 150$\mu$m or less and particularly preferably 100 $\mu$m or less. When the thickness of the resin composition layer lies within the above-mentioned range, the space between the adjacent terminals can adequately be filled with the resin composition, and thus sufficient mechanical adhesive strength and sufficient electric connection between the opposing terminals can be ensured after curing/solidification of the resin composition, thereby allowing production of a connection terminal.

When the conductive connecting material of the present invention contains a plurality of the resin composition layers, the composition of each resin composition layer may be the same or different according to the types and formulations of the resin components used. The properties of the resin composition layer, such as melting viscosity and the softening temperature, may also be the same or different. For example, a resin composition layer in a liquid form and a resin composition layer in a solid form may be used in combination.

(2) Metal foil (Metal layer)

According to the present invention, a metal foil layer is a layer composed of a metal foil selected from a solder foil or a tin foil. A metal foil layer may be formed on at least a part of the resin composition layer or the whole area of the resin composition layer when seen in a planar view.

The shape of the metal foil layer is not particularly limited, and it may be formed into a repeated pattern of a certain shape, or into irregular shapes. Regular and irregular shapes may be present together. Figure 1 is a schematic plan view showing examples of the shapes of the metal foil layers. Various shapes of metal foil layers 110 are disposed on resin composition layers 120. Examples of the shape of the metal foil layer include, as shown in Figure 1, a punched-out dot pattern (a), a stripe pattern (b), a polka-dot pattern (c), a rectangular pattern (d), a checkered pattern (e), a frame pattern (f), a lattice pattern (g) and a multi-frame pattern (h). These shapes are merely a part of examples, and they may be combined together or their shapes may be modified according to the purpose or application.

According to one embodiment of the present invention, when full grid adherends, in which the electrodes to be connected are arranged all over the connecting surface of the adherend, are to be connected electrically, a sheet-like metal foil is preferably disposed on the whole surface of the resin composition.

When peripheral-type adherends, in which the electrodes to be connected are arranged on the peripheral area of the connecting surface of the adherend, are to be connected electrically, a metal foil having a repeated pattern is preferably formed on at least part of the resin composition in terms of effective use of the metal foil and prevention of the metal foil to remain between the adjacent electrodes. In this case, the shape of the metal foil may appropriately be selected according to the pitch or form of the electrodes.

A metal foil used with the present invention is not particularly limited, but it is preferably an alloy of at least two or more types of metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone.

Among them, a metal foil is more preferably a solder foil of an alloy containing Sn such as an alloy of Sn-Pb, or a lead-free solder of an alloy of Sn-Bi, an alloy of Sn-Ag-Cu, an alloy of Sn-In or an alloy of Sn-Ag considering the melting temperature and the mechanical properties. When an alloy of Sn-Pb is used, the content rate of tin is preferably 30% by weight or more and less than 100% by weight, more preferably 35% by weight or more and less than 100% by weight, and preferably 40% by weight or more and less than 100% by weight. In the case of a lead-free solder, the content rate of tin is preferably 15% by weight or more and less than 100% by weight, more preferably 20% by weight or more and less than 100% by weight and particularly preferably 25% by weight or more and less than 100% by weight. For example, an alloy of Sn-Pb may preferably be Sn63-Pb (melting point: 183˚C), and a lead-free solder may preferably be Sn-3.0Ag-0.5Cu (melting point: 217˚C), Sn-3.5Ag (melting point: 221˚C), Sn-58Bi (melting point: 139˚C), Sn-9.0Zn (melting point: 199˚C), Sn-3.5Ag-0.5Bi-3.0In (melting point: 193˚C) and Au-20Sn (melting point: 280˚C).

A metal foil may appropriately be selected according to the heat resistance of the electronic members or the semi-conductor device to be connected. For example, for terminal-to-terminal connection in a semi-conductor device, a metal foil having the melting point of 330˚C or lower (more preferably 300˚C or lower, particularly preferably 280˚C or lower and more preferably 260˚C or lower) is preferably used in order to prevent members of a semi-conductor device from being damaged due to heat history. Furthermore, in order to ensure heat resistance of the semi-conductor device after the terminal-to-terminal connection, a metal foil having the melting point at 100˚C or higher (more preferably 110˚C or higher and particularly preferably 120˚C or higher) is preferably used. Here, the melting point of a metal foil can be measured with a differential scanning calorimeter (DSC).

The thickness of a metal foil may appropriately be selected according to the gap between the opposing terminals, distance between adjacent terminals that are spaced apart, and the like. For example, in the case of connecting the connection terminals of, for example, a semiconductor chip, a substrate and a semiconductor wafer in a semi-conductor device, the thickness of the metal foil is preferably 0.5 μm or more, more preferably 3 μm or more and particularly preferably 5 μm or more, and at the same time, preferably 100 μm or less, more preferably 50 μm or less and particularly preferably 20 μm or less. When the thickness of the metal foil is less than the above-mentioned lower limit, the number of unconnected terminals tends to increase due to lack of solder or tin. On the other hand, when the thickness exceeds the above-mentioned upper limit, bridge may occur between the adjacent terminals due to excess solder or tin, and thus likely to cause a short-circuit.

A method for producing a metal foil may be, for example, a method that produces the metal foil from a mass such as an ingot mass by rolling, or a method that forms a metal foil layer by direct evaporation, sputtering, plating or the like on a resin composition layer. A method for producing a metal foil having a repeated pattern may be, for example, a method in which a metal foil is punched out into a predetermined pattern, a method in which a predetermined pattern is formed by etching, and a method which forms a pattern by evaporation, sputtering, plating or the like using a shielding plate or mask.

According to the present invention, the form of the conductive connecting material may appropriately be selected according to the form of the resin composition. For example, when the resin composition is in a liquid form, a conductive connecting material can be provided: as a metal foil having the resin composition applied on both sides; or as a film obtained by applying the resin composition to a peelable base material such as a polyester sheet, which is dried at a predetermined temperature for the purpose of half-curing (B-stage curing) and film-forming, and then layering the metal foils together. When the resin composition is in a solid form, a conductive connecting material can be provided as a film obtained by applying a varnish of the resin composition dissolved in an organic solvent onto a peelable base material such as a polyester sheet, which is dried at a predetermined temperature, and then layering the metal foils together or by employing a technique such as evaporation.

The conductive connecting material of the present invention and a metal foil used therefor may be embossed in order to enhance contact with the terminal.

The thickness of the conductive connecting material of the present invention is not particularly limited, but it is preferably 1 μm or more, more preferably 3 μm or more and particularly preferably 5 μm or more, and at the same time, preferably 200 μm or less, more preferably 150 μm or less and particularly preferably 100 μm or less. When the thickness of the conductive connecting material is within the above-mentioned range, the void between the adjacent terminals can adequately be filled in with the resin composition. Moreover, mechanical adhesive strength and electric connection between the opposing terminals after curing or solidification of the resin component can be ensured to be sufficient. In addition, a connection terminal can be produced according to the purpose or application.

Hereinafter, a method for producing a conductive connecting material will be described.
When a resin composition used with the present invention is in a liquid form at 25˚C, for example, a metal foil can be immersed in a resin composition in a liquid form to apply the resin composition in the liquid form onto both sides of the metal foil, thereby producing a conductive connecting material of the present invention. When the thickness of the resin composition needs to be controlled, the conductive connecting material may be produced by a method in which the metal foil immersed in the resin composition in the liquid form is passed through a bar coater having a certain gap or by a method in which the resin composition in the liquid form is sprayed using a spray coater or the like.

When a resin composition used with the present invention is in a film form at 25˚C, a conductive connecting material may be produced, for example, as follows. First, a varnish of a resin composition dissolved in an organic solvent is applied onto a peelable base material such as a polyester sheet and dried at a predetermined temperature to form a resin composition in a film form. Then, two resin composition films formed on peelable base materials are prepared to sandwich a metal foil, which are then laminated by heat rolling, thereby producing a three-layered conductive connecting material consisting of resin composition/metal foil/resin composition where the resin compositions are arranged above and beneath the metal foil. Alternatively, according to the above-described lamination method, a two-layered conductive connecting material consisting of resin composition/metal foil can also be produced by arranging the resin composition on one side of the metal foil.

When a rolled metal foil is used, the metal foil is used as a base material, where the above-described film-type

resin composition is laminated on both sides or one side of the metal foil by heat rolling, thereby obtaining a conductive connecting material in a roll. Furthermore, when a rolled metal foil is used, a varnish-type resin composition may directly be applied to both sides or one side of the metal foil while volatizing the solvent, thereby producing a conductive connecting material in a roll.

When a patterned metal foil is used to produce a conductive connecting material, the metal foil is arranged on a peelable base material, then the metal foil is half-cut with a die cut mold from the metal foil side. The excessive metal foil is removed to produce a patterned metal foil, on which the above-described resin composition in the film form can be laminated by heat rolling. When a resin composition is to be provided on both sides of the patterned metal foil, the above-described peelable base material is peeled off, and the film-type resin composition is additionally laminated on the metal foil on the side opposite from the side having the resin composition.

The method for producing a conductive connecting material is not limited to the above-described method. A method for producing a conductive connecting material may appropriately be selected by those skilled in the art according to purpose and application.

2. Method for connecting terminals

Hereinafter, a method for connecting terminals according to the present invention will be described.

A connection method of the present invention comprises a method for connecting terminals using the above-described conductive connecting material, where the method comprises the steps of: arranging a conductive connecting material between opposing terminals; heating the conductive connecting material; and curing or solidifying the resin composition. The connection method of the present invention may be used, for example, for connecting terminals formed on a semiconductor wafer, a semiconductor chip, a rigid substrate, a flexible substrate, and other electrical and electronic components.

According to the connection method of the present invention, when the area occupancy of a terminal with respect to the adhesion area between the adherend including the terminal and the conductive connecting material is 3% to 50%, the conductive connecting material used preferably has the volume ratio ((A)/(B)) of a resin composition (A) and a metal foil (B) selected from a solder foil or a tin foil of 1-40, preferably 2-30, more preferably 3-25 and still more preferably 4-20 in the conductive connecting material. On the other hand, when the area occupancy of a terminal with respect to the adhesion area between the adherend including the terminal and the conductive connecting material is 0.1% to less than 3%, the conductive connecting material used preferably has the volume ratio ((A)/(B)) of 20-500, preferably 25-400, more preferably 30-300 and still more preferably 35-200. According to the present invention, the volume ratio of a resin composition (A) and a metal foil (B) in the conductive connecting material can be altered according to the area occupancy of the terminal with respect to the adhesion area of the adherend, thereby realizing favorable electric connection between the connection terminals and highly-reliable insulation between the adjacent terminals.

The steps of the connection method of the present invention slightly varies between the case where the resin composition of the conductive connecting material is a curable resin composition and the case where it is a thermoplastic resin composition. Hereinafter, each of the cases will be described.

(1) Case where resin composition is curable resin composition

When the resin composition used for the conductive connecting material is a curable resin composition, the method for connecting terminals according to the present invention comprises the steps of: arranging the conductive connecting material including the above-described curable resin composition and a metal foil between opposing terminals; heating the conductive connecting material at a temperature that is equal to or higher than the melting point of the metal foil and that does not complete curing of the curable resin composition; and curing the curable resin composition.

According to this connection method, heat-melted solder or tin can selectively be aggregated between the terminals to form a conductive region while a curable resin composition can be formed as an insulating region around the conductive region. As a result, insulation between the adjacent terminals can be ensured to prevent a leakage current, thereby enhancing connection reliability between the terminals. Moreover, electric connection of a plurality of terminals can collectively be carried out even in a fine pitch circuit. Furthermore, curing of the curable resin composition increases the mechanical strength of the conductive region or the insulating region.

Hereinafter, a preferable embodiment of a method for connecting terminals where the resin composition of the conductive connecting material is a curable resin composition will be described with reference to the drawings, although the connection method of the present invention is not limited to these drawings.

(a) Arrangement step

First, as shown in Figure 2, a substrate 10 provided with terminals 11 is aligned with a substrate 20 provided

with terminals 21 such that the terminals 11 oppose the terminals 21. Between these terminals, a conductive connecting material 30 comprising a metal foil 110 and curable resin compositions 120 provided on both sides of the metal foil 110 is arranged. In doing so, the conductive connecting material 30 may be compressed onto either or both sides of the substrates 10 and 20 beforehand using an instrument such as a roll laminator or a press as shown in Figure 4. If necessary, the surface of the terminals 11 and 21 may be subjected to treatments such as washing, polishing, plating and surface activation in order to achieve good electric connection.

(b) Heating step

In the heating step, the conductive connecting material arranged between the terminals in the above-described arrangement step is heated at a temperature equal to or higher than the melting point of the metal foil. The heating temperature may be equal to or higher than the melting point of the metal foil, and the upper limit thereof is not particularly limited as long as solder or tin is able to migrate within the curable resin, in other words, as long as the temperature is within the range where "the curable resin composition is not completely cured", for example, by adjusting the heating time, e.g., making the heating time shorter. The heating temperature is preferably higher by 5˚C or more, more preferably higher by 10˚C or more, still more preferably higher by 20˚C or more and particularly preferably higher by 30˚C or more than the melting point of the metal foil.

The heating temperature may appropriately be selected according to the composition of the metal foil and the curable resin composition used, but it is preferably 100˚C or higher, more preferably 130˚C or higher, particularly preferably 140˚C or higher and most preferably 150˚C or higher. In order to prevent thermal degradation of the substrates to be connected, the heating temperature is preferably 260˚C or lower, more preferably 250˚C or lower and particularly preferably 240˚C or lower.

When the conductive connecting material is heated at such a temperature, the metal foil 110 is melted and the melted solder or tin can migrate in the curable resin composition 120. When the curable resin composition contains a compound having a phenolic hydroxyl group and/or a carboxyl group, the oxide layer on the solder or tin surface is removed due to the reduction action of the compound having a phenolic hydroxyl group and/or a carboxyl group contained in the curable resin composition, and thus the wettability of the solder or tin remains in an enhanced state, which promotes metal-binding and facilitates aggregation between the opposing terminals. On the other hand, since the reduction action of the compound having a phenolic hydroxyl group and/or a carboxyl group also removes the oxide layer on the surfaces of the terminals 11 and 21 and enhances wettability thereof, metal-binding with the solder or tin is facilitated. As a result, as shown in Figure 3, a conductive region 130 is formed between the terminals, where the terminals 11 and 21 are electrically connected. Meanwhile, the surrounding area of the conductive region is filled with the curable resin composition as an insulating region 140. As a result, insulation between the adjacent terminals can be ensured, thereby preventing short-circuit between the adjacent terminals.

According to the connection method of the present invention, heating may take place while applying a pressure so as to reduce the distance between the opposing terminals. For example, a known thermal compressor or the like may be used for heating and compressing the substrates 10 and 20 shown in Figure 2 toward the facing direction so that the distance between each pair of the opposing terminals can be controlled to stay constant, thereby enhancing electric connection reliability between the opposing terminals.

Furthermore, ultrasonic wave, an electric field or the like may be applied or special heating such as laser or electromagnetic induction may be applied upon compression or heating.

(c) Curing step

According to the connection method of the present invention, after forming the conductive region 130 and the insulating region 140 in the above-described heating step, the curable resin composition is cured to fix the insulating region 140. By doing so, sufficient electrical reliability and mechanical connection strength between the terminals can be ensured. In particular, according to the connection method of the present invention, since a curable resin composition having a high insulation resistance value is used, sufficient insulation of the insulating region can be ensured.

Curing of the curable resin composition can be carried out by heating the conductive connecting material. The curing temperature of the conductive connecting material may appropriately be determined according to the composition of the curable resin composition, but it is preferably a temperature lower by at least 5˚C and particularly preferably a temperature lower by at least 10˚C than the heating temperature in the above-described heating step. Specifically, the curing temperature is preferably 100˚C or higher, more preferably 120˚C or higher, particularly preferably 130˚C or higher and most preferably 150˚C or higher. At the same time, the curing temperature is preferably 300˚C or lower, more preferably 260˚C or lower, particularly preferably 250˚C or lower and most preferably 240˚C or lower. When the curing temperature lies within the above-mentioned range, the conductive connecting material is not degraded by heat, and thus the curable resin composition can adequately be cured.

(2) Case where resin composition is thermoplastic resin composition

Next, a method for connecting terminals where the resin composition is a thermoplastic resin composition will be described. In the case where the resin composition used as the conductive connecting material is a thermoplastic resin composition, the method for connecting terminals according to the present invention comprises the steps of: arranging a conductive connecting material containing the above-described thermoplastic resin composition and a metal foil between opposing terminals; heating the conductive connecting material at a temperature that is equal to or higher than the melting point of the metal foil and that softens the thermoplastic resin composition; and solidifying the thermoplastic resin composition. Hereinafter, each step will be described.

(a) Arrangement step

The conductive connecting material containing the thermoplastic resin composition and the metal foil can also be arranged in the same manner as the above-described conductive connecting material containing the curable resin composition and the metal foil.

(b) Heating step

The heating step is not particularly limited, but the conductive connecting material arranged between the terminals in the above arrangement step is heated at a temperature equal to or higher than the melting point of the metal foil. The heating temperature is preferably higher by 5˚C or more, more preferably higher by 10˚C or more, further preferably higher by 20˚C or more and particularly preferably higher by 30˚C or more than the melting point of the metal foil. The upper limit of the heating temperature is not particularly limited as long as it is equal to or higher than the melting point of the metal foil and it softens the thermoplastic resin so that the solder or tin is able to migrate within the thermoplastic resin, in other words, the temperature is within the range where "the thermoplastic resin composition is softened".

The heating temperature may appropriately be selected according to the composition of the metal foil and the thermoplastic resin composition used. For example, heating can be carried out at the same heating temperature as that for the conductive connecting material containing the curable resin composition and the metal foil.

When the conductive connecting material is heated at the above-described temperature, the metal foil 110 is melted so that the melted solder or tin can migrate in the thermoplastic resin composition 120. When the thermoplastic resin composition contains a compound having a phenolic hydroxyl group and/or a carboxyl group, the oxide layer on the solder or tin surface is removed due to the reduction action of the compound having a phenolic hydroxyl group and/or a carboxyl group contained in the thermoplastic resin composition, and thus the wettability of the solder or tin remains in an enhanced state, which promotes metal-binding and facilitates aggregation between the opposing terminals. On the other hand, since the reduction action of the compound having a phenolic hydroxyl group and/or a carboxyl group also removes the oxide layer on the surfaces of the terminals 11 and 21 and enhances wettability thereof, metal-binding with the solder or tin is facilitated. As a result, as shown in Figure 3, a conductive region 130 is formed between the terminals, where the terminals 11 and 21 are electrically connected. Meanwhile, the surrounding area of the conductive region is filled with the thermoplastic resin composition as an insulating region 140. As a result, insulation between the adjacent terminals can be ensured, thereby preventing short-circuit between the adjacent terminals.

(c) Solidification step

According to the connection method of the present invention, after forming the conductive region 130 and the insulating region 140 in the heating step, the thermoplastic resin composition is solidified to fix the insulating region 140. By doing so, sufficient electrical reliability and mechanical connection strength between the terminals can be ensured.

Solidification of the thermoplastic resin composition may be carried out by cooling/solidifying the conductive connecting material that has been heat-melted in the above-described heating step. The cooling/solidification of the conductive connecting material may appropriately be determined according to the composition of the thermoplastic resin composition, which is not particularly limited, and it may be a method carried out by natural cooling or a method carried out by spraying cool air.

The solidifying temperature of the thermoplastic resin composition is not particularly limited but it is preferably lower than the melting point of a metal foil. More specifically, the solidifying temperature of the thermoplastic resin composition is preferably lower by 10˚C or more and particularly preferably lower by 20˚C or more than the melting point of the metal foil. At the same time, the solidifying temperature of the thermoplastic resin composition is preferably 50˚C or higher, particularly preferably 60˚C or higher, and still more preferably 100˚C or higher. When the solidifying temperature of the thermoplastic resin composition lies within the above-mentioned range, formation of the conductive region 130 can be ensured, and the insulating region 140 may have a desirable heat resistance. As a result, insulation between

the adjacent terminals can be ensured, thereby more reliably preventing short-circuit between the adjacent terminals.

In a preferable aspect of the present invention, by using a conductive connecting material comprising a resin composition containing a certain resin component and a compound having a phenolic hydroxyl group and/or a carboxyl group and a metal foil, the solder or tin can selectively be aggregated between the opposing terminals to electrically connect the terminals and ensuring insulation between the adjacent terminals. Furthermore, a plurality of terminals can be conducted collectively and terminal-to-terminal connection can be realized with excellent reliability.

3. Electronic members associated with conductive connecting material and electrical and electronic components

The present invention also comprises an electronic member associated with a conductive connecting material, where the conductive connecting material of the present invention is adhered to the electrically connecting surface of the electronic member. In the electronic member associated with the conductive connecting material of the present invention, the surface of the conductive connecting material that adheres to the electrically connecting surface of the electronic member is preferably a resin composition layer. The resin composition layer may be adhered directly to the electrically connecting surface of the electronic member, or may be adhered via an adhesive layer. The electronic members associated with the conductive connecting material of the present invention may be layered with each other or the electronic member associated with the conductive connecting material of the present invention may be layered with an electrically connecting surface of other electronic member, which are then thermally compressed with each other so as to electrically connect the electronic members.

The present invention also comprises a semiconductor wafer, a semiconductor chip, a rigid substrate, a flexible substrate and other electrical and electronic components in which electronic members are electrically connected using the thus-obtained conductive connecting material of the present invention.

EXAMPLES

Hereinafter, the present invention will be described by way of examples, although the present invention should not be limited to the following examples.

Examples 1-4

(1) Preparation of curable resin composition

The components shown in Table 1 were dissolved in methylethyl ketone (MEK) to obtain a varnish of a resin composition having a solid content of 40%. The obtained varnish was applied onto a polyester sheet with a comma coater, and dried at 90˚C for 5 minutes to obtain two sheets of film-like curable resin composition with a thickness shown in Table 1.

(2) Production of conductive connecting material

The resulting film-like curable resin composition was laminated on both sides of the solder foil having a thickness shown in Table 1 under the conditions of 60˚C, 0.3MPa and 0.3m/min to produce a conductive connecting material.

The volume ratio ((A)/(B)) of the resin composition (A) and the metal foil (B) was derived as follows and shown in Table 1.

$$\text{Volume ratio } ((A)/(B)) = (S(B) - S)/(S - S(A))$$

S: Specific gravity of conductive connecting material
S(A): Specific gravity of resin composition
S(B): Specific gravity of metal foil

Each of the specific gravities was determined as follows based on the weight in air and weight in water.

$$\text{Specific gravity } S = W/(W - W1)$$

W: Weight in air (g)
W1: Weight in water (g)

(3) Terminal-to-terminal connection

Then, the resulting conductive connecting material was used to carry out terminal-to-terminal connection of a substrate. The substrate used consisted of FR-4-based material (thickness: 0.1 mm) and a circuit layer (copper circuit, thickness: 12 μm), which had connection terminals formed by plating Ni/Au (thickness: 3μm) on the copper circuit (terminal diameter and distance between centers of adjacent terminals are shown in Table 1). The gaps between the substrates and the area occupancy (%) of the electrode (pad) with respect to the adhesion area between the resin composition and the metal foil are shown in Table 1.
The conductive connecting material was arranged between such substrates having the connection terminals, to which thermal compression was performed using a thermal compressor ("TMV1-200ASB" from Tsukuba Mechanics) under the conditions shown in Table 1 to connect the terminals. Thereafter, the curable resin composition was cured by heating at 180˚C for an hour, thereby obtaining a multilayered body.

Example 5

A curable resin composition having the thickness shown in Table 1 was prepared in the same manner as Examples 1-4. The resulting film-like curable resin composition was laminated on both sides of a frame-like solder foil having the thickness shown in Table 1, inner dimension of 8 mm x 8 mm and outer dimension of 10 mm x 10 mm under the conditions of 60˚C, 0.3 MPa and 0.3 m/min to provide a conductive connecting material.
The volume ratio ((A)/(B)) of the resin composition (A) and the metal foil (B) was determined according to the above-described method and shown in Table 1. In addition, the resulting conductive connecting material was used for terminal-to-terminal connection of the substrates in the same manner as Examples 1-4 (method described in "(3) Terminal-to-terminal connection" above) except that the substrate used consisted of FR-4-based material (thickness: 0.1 mm) and a circuit layer (copper circuit, thickness: 12 μm), which had a row of connection terminals formed along the outer edge by plating Ni/Au (thickness: 3μm) on the copper circuit (terminal diameter and distance between centers of adjacent terminals are shown in Table 1). The terminal diameter, the distance between the centers of the adjacent terminals, the gaps between the substrates and the area occupancy (%) of the electrode (pad) with respect to the adhesion area of the substrate are shown in Table 1.

Example 6

A curable resin composition having the thickness shown in Table 1 was prepared in the same manner as Examples 1-4. The resulting film-like curable resin composition was laminated on both sides of a frame-like solder foil having the thickness shown in Table 1, inner dimension of 9 mm x 9 mm and outer dimension of 10 mm x 10 mm under the conditions of 60˚C, 0.3 MPa and 0.3 m/min to provide a conductive connecting material. The volume ratio ((A)/(B)) of the resin composition (A) and the metal foil (B) was determined according to the above-described method and shown in Table 1. The resulting conductive connecting material was used for terminal-to-terminal connection of the substrates in the same manner as Examples 1-4 (method described in "(3) Terminal-to-terminal connection" above) except that the substrate used consisted of FR-4-based material (thickness: 0.1 mm) and a circuit layer (copper circuit, thickness: 12 μm), which had two rows of connection terminals formed along the outer edge by plating Ni/Au (thickness: 3μm) on the copper circuit. The terminal diameter, the distance between the centers of the adjacent terminals, the gaps between the substrates and the area occupancy (%) of the electrode (pad) with respect to the adhesion area of the substrate are shown in Table 1.

Comparative example 1

A curable resin composition having the thickness shown in Table 2 was prepared in the same manner as Examples 1-4. The resulting film-like curable resin composition was laminated on both sides of a solder foil having the thickness shown in Table 2 under the conditions of 60˚C, 0.3 MPa and 0.3 m/min to provide a conductive connecting material. The volume ratio ((A)/(B)) of the resin composition (A) and the metal foil (B) was determined according to the above-described method and shown in Table 2. In addition, the resulting conductive connecting material was used for terminal-to-terminal connection of the substrates in the same manner as Examples 1-4 (method described in "(3) Terminal-to-terminal connection" above). The terminal diameter, the distance between the centers of the adjacent terminals, the gaps between the substrates and the area occupancy (%) of the electrode (pad) with respect to the adhesion area of the substrate are shown in Table 2.

Comparative example 2

A curable resin composition having the thickness shown in Table 2 was prepared in the same manner as Examples 1-4. The resulting film-like curable resin composition was laminated on both sides of a frame-like solder foil having the thickness shown in Table 1, inner dimension of 9 mm x 9 mm and outer dimension of 10 mm x 10 mm under the conditions of 60˚C, 0.3 MPa and 0.3 m/min to provide a conductive connecting material. The volume ratio ((A)/(B)) of the resin composition (A) and the metal foil (B) was determined according to the above-described method and shown in Table 1. The resulting conductive connecting material was used for terminal-to-terminal connection of the substrates in same manner as Examples 1-4 (method described in "(3) Terminal-to-terminal connection" above) except that the substrate used consisted of FR-4-based material (thickness: 0.1 mm) and a circuit layer (copper circuit, thickness: 12 μm), which had a row of connection terminals formed along the outer edge by plating Ni/Au (thickness: 3μm) on the copper circuit (terminal diameter and distance between centers of adjacent terminals are shown in Table 1). The terminal diameter, the distance between the centers of the adjacent terminals, the gaps between the substrates and the area occupancy (%) of the electrode (pad) with respect to the adhesion area of the substrate are shown in Table 1.

Reference example 1

A curable resin composition having the thickness shown in Table 2 was prepared in the same manner as Examples 1-4. The resulting film-like curable resin compositions was laminated on both sides of a solder foil having the thickness shown in Table 2 under the conditions of 60˚C, 0.3 MPa and 0.3 m/min to provide a conductive connecting material. The volume ratio ((A)/(B)) of the resin composition (A) and the metal foil (B) was determined according to the above-described method and shown in Table 2. In addition, the resulting conductive connecting material was used for terminal-to-terminal connection of the substrates in the same manner as Examples 1-4 (method described in "(3) Terminal-to-terminal connection" above). The terminal diameter, the distance between the centers of the adjacent terminals, the gaps between the substrates and the area occupancy (%) of the electrode (pad) with respect to the adhesion area of the substrate are shown in Table 2.

Reference example 2

A curable resin composition having the thickness shown in Table 2 was prepared in the same manner as Examples 1-4. The resulting film-like curable resin composition was laminated on both sides of a solder foil having the thickness shown in Table 2 under the conditions of 60˚C, 0.3 MPa and 0.3 m/min to provide a conductive connecting material. The volume ratio ((A)/(B)) of the resin composition (A) and the metal foil (B) was determined according to the above-described method and shown in Table 2. The resulting conductive connecting material was used for terminal-to-terminal connection of the substrates in the same manner as Examples 1-4 (method described in "(3) Terminal-to-terminal connection" above) except that the substrate used consisted of FR-4-based material (thickness: 0.1 mm) and a circuit layer (copper circuit, thickness: 12 μm), which had two rows of connection terminals formed along the outer edge by plating Ni/Au (thickness: 3μm) on the copper circuit (terminal diameter and distance between centers of adjacent terminals are shown in Table 1). The terminal diameter, the distance between the centers of the adjacent terminals, the gaps between the substrates and the area occupancy (%) of the electrode (pad) with respect to the adhesion area of the substrate are shown in Table 2.

The electrical resistance between the opposing terminals, formation of conductivity path and presence or absence of residual solder particles in regions other than the conductivity path in the laminated bodies obtained in Examples, Comparative examples and Reference examples were assessed according to the following methods.

(1) Electrical resistance

Electrical resistance between the opposing terminals of the multilayered body was measured by 12 point measurement using four-terminal method (resistance meter: "Digital Multimeter VOA7510" from Iwatsu Electric, measurement probe: "Pin-type lead 9771" from Hioki E.E.). The assessments were as follows: "A" when the average value was less than 30 mΩ; and "B" when the average value was equal to or higher than 30 mΩ.

(2) Formation of conductivity path

For 10 pairs of opposing terminals of the multilayered body, the cross-sections between the terminals were observed with a scanning electronic microscope (SEM) ("JSM-7401F" from JEOL). Assessments were as follows: "A" when cylindrical conductivity paths were formed with solder in all of the 10 pairs; "B" when any pair of terminals failed to form a conductivity path; and "C" when a short-circuit is made with the adjacent terminals.

(3) Presence and absence of residual solder

The cross-section of the multilayered body was observed with a scanning electronic microscope (SEM) (model number "JSM-7401F" from JEOL), and it was assessed as follows: "A" when the entire solder contributed to the formation of the conductivity path between opposing terminals; and "B" when the solder did not entirely contribute to the formation of the conductivity path and remained in a region of the resin (insulating region) other than the region between the opposing terminals (conductive region).

The results are shown in Tables 1 and 2.

Table 1

| | | | Example 1 | Example 2 | Example 3 | Example 4 | Example 5 | Example 6 |
|---|---|---|---|---|---|---|---|---|
| Composition [parts by weight] | Resin composition | Epoxy resin | 40.0 | | | | | |
| | | Curing agent | 25.0 | | | | | |
| | | Polymer component | 30.0 | | | | | |
| | | Compound with fluxing function, having phenolic hydroxyl group and/or carboxyl group | 4.5 | | | | | |
| | | Silane coupling agent | 0.5 | | | | | |
| | | Imidazole | 0.01 | | | | | |
| | | Total | 100.0 | | | | | |
| | Metal foil | Solder foil A | ○ | | | | | |
| | | Solder foil B | | ○ | | | ○ | ○ |
| | | Solder foil C | | | ○ | | | |
| | | Solder foil D | | | | ○ | | |
| | | Solder foil E | | | | | | |
| | Thickness of resin composition [μm] | | 25 | 25 | 100 | 25 | 58 | 25 |
| | Thickness of metal foil [μm] | | 10 | 5 | 50 | 10 | 5 | 5 |
| | Thickness of conductive connecting material [μm] | | 60 | 55 | 250 | 60 | 120 | 55 |
| | Volume ratio of resin composition and metal foil [-] | | 5.0 | 10.0 | 4.0 | 5.0 | 65.7 | 56.9 |
| Substrate | Terminal diameter [μm] | | 50 | 40 | 200 | 50 | 100 | 50 |
| | Distance between centers of adjacent terminals [μm] | | 100 | 100 | 300 | 100 | 200 | 100 |
| | Gap between substrates [μm] | | 50 | 35 | 200 | 50 | 100 | 50 |
| | Area occupancy of pad to adhesion area [%] | | 19.6 | 12.6 | 34.9 | 19.6 | 1.6 | 1.6 |
| Substrate connecting conditions | Thermal compression Conditions | Temperature [°C] | 200 | 200 | 200 | 230 | 200 | 200 |
| | | Pressure [MPa] | 0.5 | 0.5 | 0.5 | 0.5 | 0.5 | 0.5 |
| | | Time [second] | 120 | 120 | 120 | 120 | 120 | 120 |

(continued)

| | | Example 1 | Example 2 | Example 3 | Example 4 | Example 5 | Example 6 |
|---|---|---|---|---|---|---|---|
| Evaluation Results | Electrical resistance between opposing terminals | A | A | A | A | A | A |
| | Formation of conductivity path between opposing terminals | A | A | A | A | A | A |
| | Presence or absence of residual solder | A | A | A | A | A | A |

Table 2

| | | | | Comparative Example 1 | Comparative Example 2 | Reference Example 1 | Reference Example 2 |
|---|---|---|---|---|---|---|---|
| Composition [parts by weight] | Resin composition | Epoxy resin | | 40 0 | | | |
| | | Curing agent | | 25.0 | | | |
| | | Polymer component | | 30.0 | | | |
| | | Compound having phenolic hydroxyl group and/or carboxyl group | | 4.5 | | | |
| | | Silane coupling agent | | 0.5 | | | |
| | | Imidazole | | 0.01 | | | |
| | | Total | | 100.0 | | | |
| | Metal foil | Solder foil A | | | | | |
| | | Solder foil B | | | | ○ | ○ |
| | | Solder foil C | | ○ | | | |
| | | Solder foil D | | | | | |
| | | Solder foil E | | | ○ | | |
| | Thickness of resin composition [μm] | | | 5 | 124 | 123 | 25 |
| | Thickness of metal foil [μm] | | | 50 | 2 | 5 | 5 |
| | Thickness of conductive connecting material [μm] | | | 60 | 250 | 250 | 55 |
| | Volume ratio of resin composition and metal foil [-] | | | 0.2 | 656.9 | 49.0 | 10.0 |
| Substrate | Terminal diameter [μm] | | | 50 | 200 | 200 | 50 |
| | Distance between centers of adjacent terminals [μm] | | | 100 | 500 | 300 | 100 |
| | Gap between substrates [μm] | | | 50 | 200 | 200 | 50 |
| | Area occupancy of pad to adhesion area [%] | | | 19 6 | 2.5 | 34.9 | 1.6 |
| Substrate connecting conditions | Thermal compression Conditions | | Temperature [°C] | 200 | 200 | 200 | 200 |
| | | | Pressure [MPa] | 0.5 | 0.5 | 0.5 | 0.5 |
| | | | Time [second] | 120 | 120 | 120 | 120 |
| Evaluation Results | Electrical resistance between opposing terminals | | | A | B | B | A |
| | Formation of conductivity path between opposing terminals | | | B | B | B | B |
| | Presence or absence of residual solder | | | B | B | B | B |

The components of the resin compositions and the solder foils used in Table 1 and 2 are shown below.

(1) Epoxy resin: Bisphenol-A epoxy resin, "EPICLON-840S" from Dainippon Ink and Chemicals, epoxy equivalent: 185 g/eq

(2) Curing agent: Phenol novolac, "PR-53647" from Sumitomo Bakelite

(3) Polymer component: Modified, biphenol phenoxy resin, "YX-6954" from Japan Epoxy Resin, weight-average molecular weight: 39,000

(4) Compound having a phenolic hydroxyl group and/or a carboxyl group: Sebacic acid, "Sebacic acid" from Tokyo Chemical Industry

(5) Silane coupling agent: 2-(3,4-epoxycyclohexyl)ethyltrimethoxysilane, "KBM-303" from Shin-Etsu Chemical

(6) Imidazole: 2-phenyl-4-methylimidazole, "Curezol 2P4MZ" from Shikoku Chemicals

(7) Solder foil A: Sn/Pb = 63/37 (melting point: 183˚C), thickness: 10 μm

(8) Solder foil B: Sn/Pb = 63/37 (melting point: 183˚C), thickness: 5 μm

(9) Solder foil C: Sn/Pb = 63/37 (melting point: 183˚C), thickness: 50 μm

(10) Solder foil D: Sn/Ag/Cui = 96.5/3.0/0.5 (melting point: 217˚C), thickness: 10 μm

(11) Solder foil E: Sn/Pb = 63/37 (melting point: 183˚C), thickness: 2 μm

As can be appreciated from Table 1, according to the examples of the present invention, it was confirmed that good electric connection can be obtained without leaving solder in the insulating region by using a conductive connecting material having the volume ratio ((A)/(B)) of the resin composition (A) and the metal foil (B) within an intended range, thereby realizing highly-reliable insulation. The results from the comparative examples shown in Table 2, however, show that the conduction were partially impaired between the terminals or that the solder remained in the insulating region when the above-described volume ratio was too small or too large. Moreover, the results from the reference examples show that, even when the volume ratio ((A)/(B)) of the resin composition (A) and the metal foil (B) was within an intended range, good electric connection and insulation reliability were not obtained depending on the area occupancy of the electrodes with respect to the adhesion area of the adherend. From these results, it appears to be desirable to adjust the volume ratio ((A)/(B)) of the resin composition (A) and the metal foil (B) within an intended range according to the area occupancy of the electrodes with respect to the adhesion area of the adherend.

INDUSTRIAL APPLICABILITY

A conductive connecting material of the present invention can favorably be used for electrically connecting electronic members of an electrical or electronic component or for producing a connection terminal on a substrate. By using the conductive connecting material of the present invention, good electric connection between the electronic members as well as highly-reliable insulation can be achieved at the same time. By using the conductive connecting material of the present invention, terminal-to-terminal connection in a fine pitch circuit can be realized. Use of the conductive connecting material of the present invention can cope with the needs for enhanced performance and downsizing of electronic devices.

DESCRIPTION OF REFERENCE NUMERALS

| | |
|---|---|
| 10, 20 | Substrates |
| 11, 21 | Terminals |
| 110 | Metal foil |
| 120 | Resin composition |
| 130 | Conductive region |
| 140 | Insulating region |

**Claims**

**1.** A conductive connecting material having a multilayered structure comprising a resin composition (A) and a metal foil (B) selected from a solder foil or a tin foil, wherein the volume ratio ((A)/(B)) of the resin composition (A) and the metal foil (B) selected from a solder foil or a tin foil is 1-40 in the conductive connecting material.

**2.** The conductive connecting material according to Claim 1 for electrically connecting opposing terminals, which is used when the area occupancy of the terminal with respect to the adhesion area between the adherend including the terminal and the conductive connecting material is from 3% to 50%.

**3.** A conductive connecting material having a multilayered structure comprising a resin composition (A) and a metal

foil (B) selected from a solder foil or a tin foil, wherein the volume ratio ((A)/(B)) of the resin composition (A) and the metal foil (B) selected from a solder foil or a tin foil is 20-500 in the conductive connecting material.

**4.** The conductive connecting material according to Claim 3 for electrically connecting opposing terminals, which is used when the area occupancy of the terminal with respect to the adhesion area between the adherend including the terminal and the conductive connecting material is 0.1% to less than 3%.

**5.** The conductive connecting material according to any one of Claims 1-4, wherein the resin composition (A) comprises a polymer component having a weight-average molecular weight of 8,000-1,000,000.

**6.** The conductive connecting material according to Claim 5, wherein the polymer component comprises at least one type selected from the group consisting of a phenoxy resin, a (meth)acrylic resin and a polyimide resin.

**7.** The conductive connecting material according to Claim 5 or 6, wherein the blending amount of the polymer component is 5-50% by weight with respect to the total weight of the resin composition (A).

**8.** The conductive connecting material according to any one of Claims 1-7, wherein the resin composition (A) comprises a compound having a phenolic hydroxyl group and/or a carboxyl group.

**9.** The conductive connecting material according to Claim 8, wherein the compound having a phenolic hydroxyl group and/or a carboxyl group comprises a compound represented by General Formula (1) below:

$$HOOC\text{-}(CH_2)n\text{-}COOH \qquad (1)$$

where, n is an integer of 1-20.

**10.** The conductive connecting material according to Claim 8 or 9, wherein the compound having a phenolic hydroxyl group and/or a carboxyl group comprises a compound represented by General Formula (2) and/or (3) below:

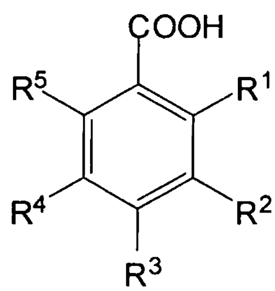

(2)

where, $R^1$-$R^5$ are each independently a monovalent organic group, provided that at least one of $R^1$-$R^5$ is a hydroxyl group,

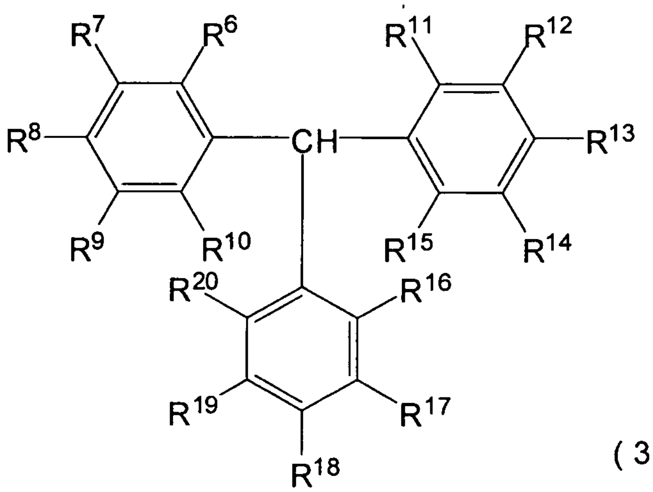

(3)

where, $R^6$-$R^{20}$ is each independently a monovalent organic group, provided that at least one of $R^6$-$R^{20}$ is a hydroxyl group or a carboxyl group.

**11.** The conductive connecting material according to any one of Claims 1-10, wherein the melting point of the metal foil is 100˚C-330˚C.

**12.** The conductive connecting material according to any one of Claims 1-11, comprising a multilayered structure comprising resin composition layer/metal foil layer/resin composition layer.

**13.** The conductive connecting material according to any one of Claims 1-11, comprising a multilayered structure comprising resin composition layer/metal foil layer.

**14.** A method for connecting terminals comprising the steps of: arranging the conductive connecting material according to any one of Claims 1-13 between the opposing terminals; heating the conductive connecting material at a temperature that is equal to or higher than the melting point of the metal foil and that does not complete curing of the resin composition; and curing the resin composition, wherein:

when the area occupancy of the terminal with respect to the adhesion area between the adherend including the terminals and the conductive connecting material is 3% to 50%, the conductive connecting material used has a volume ratio ((A)/(B)) of a resin composition (A) and a metal foil (B) selected from a solder foil or a tin foil of 1-40 in the conductive connecting material; and

when the area occupancy of the terminal with respect to the adhesion area between the adherend including the terminals and the conductive connecting material is 0.1% to less than 3%, the conductive connecting material used has a volume ratio ((A)/(B)) of a resin composition (A) and a metal foil (B) selected from a solder foil or a tin foil of 20-500 in the conductive connecting material.

**15.** A method for connecting terminals comprising the steps of: arranging the conductive connecting material according to any one of Claims 1-13 between opposing terminals; heating the conductive connecting material at a temperature that is equal to or higher than the melting point of the metal foil and that softens the resin composition; and solidifying the resin composition, wherein:

when the area occupancy of the terminal with respect to the adhesion area between the adherend including the terminals and the conductive connecting material is 3% or 50%, the conductive connecting material used has a volume ratio ((A)/(B)) of a resin composition (A) and a metal foil (B) selected from a solder foil or a tin foil of 1-40 in the conductive connecting material; and

when the area occupancy of the terminal with respect to the adhesion area between the adherend including the terminals and the conductive connecting material is 0.1% to less than 3%, the conductive connecting material used has a volume ratio ((A)/(B)) of a resin composition (A) and a metal foil (B) selected from a solder foil or a tin foil of 20-500 in the conductive connecting material.

**16.** An electric or electronic component, wherein electronic members are electrically connected using the conductive connecting material according to any one of Claims 1-13.

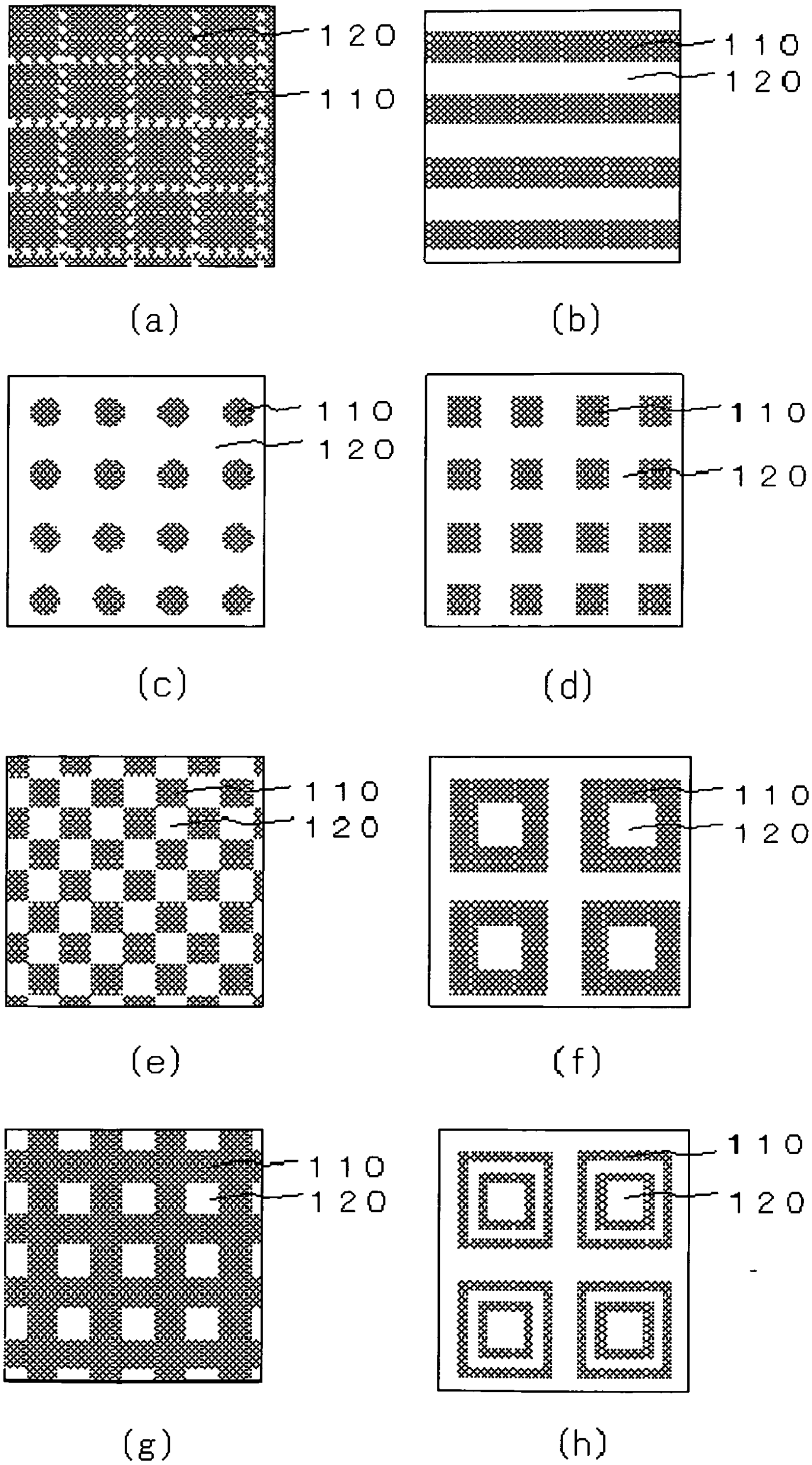
120
110
(a)
110
120
(b)
110
120
(c)
110
120
(d)
110
120
(e)
110
120
(f)
110
120
(g)
110
120
(h)

Fig. 1

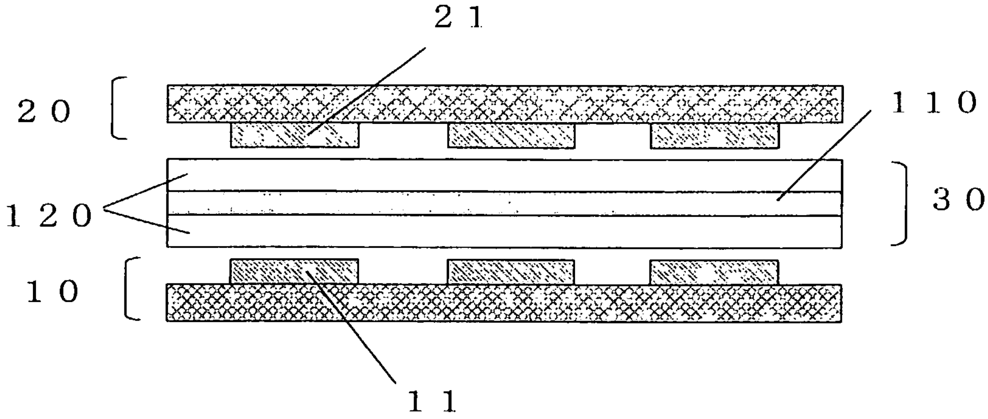


Fig. 2

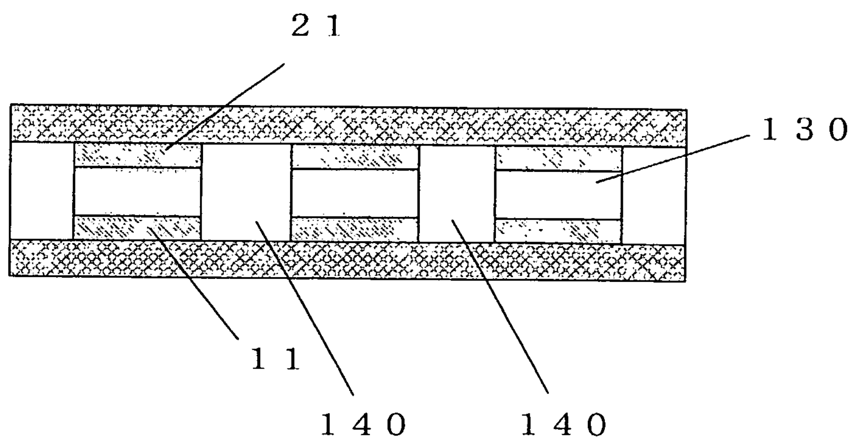


Fig. 3

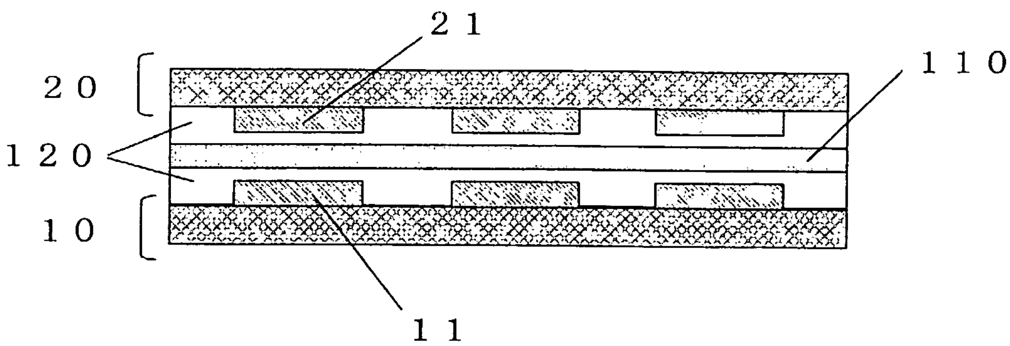


Fig. 4

**INTERNATIONAL SEARCH REPORT**

International application No.
PCT/JP2010/069020

A. CLASSIFICATION OF SUBJECT MATTER
*H01R11/01*(2006.01)i, *H01B5/16*(2006.01)i, *H01L21/60*(2006.01)i, *H05K3/36* (2006.01)i

According to International Patent Classification (IPC) or to both national classification and IPC

B. FIELDS SEARCHED

Minimum documentation searched (classification system followed by classification symbols)
H01R11/01, H01B5/16, H01L21/60, H05K3/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 11-135174 A (Sumitomo Bakelite Co., Ltd.), 21 May 1999 (21.05.1999), paragraphs [0011] to [0024]; fig. 1 to 4 (Family: none) | 1-16 |
| A | JP 2009-26700 A (Sumitomo Electric Industries, Ltd.), 05 February 2009 (05.02.2009), paragraphs [0023] to [0080]; fig. 1 to 8 (Family: none) | 1-16 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 November, 2010 (18.11.10) | 30 November, 2010 (30.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 61276873 A
- JP 2004260131 A